# EUROPÄISCHE PATENTSCHRIFT

(11) **EP 1 116 180 B1**
(45) Veröffentlichungstag und Bekanntmachung des Hinweises auf die Patenterteilung: **02.10.2002**
(21) Anmeldenummer: 99944118.1
(22) Anmeldetag: 27.08.1999
(51) Int. Cl.: G06K 19/077

(54) **VERFAHREN ZUR KONTAKTIERUNG EINES SCHALTUNGSCHIPS**
METHOD FOR CONTACTING A CIRCUIT CHIP
PROCEDE DE COLLAGE D'UNE PUCE DE CIRCUIT

(30) Priorität: 03.09.1998 DE 19840193; 01.10.1998 DE 19845296
(43) Veröffentlichungstag der Anmeldung: 18.07.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: FEIL, Michael, D-81475 München (DE)
(74) Vertreter: Schoppe, Fritz, Dipl.-Ing.
(86) Internationale Anmeldenummer: EP9906311
(87) Internationale Veröffentlichungsnummer: WO00014679

(56) Entgegenhaltungen:
- EP-A- 0 772 153
- WO-A-98/44452
- DE-A- 4 431 606
- DE-A- 19 642 378
- WADA H. ET AL. IEEE J. OF SELECTED TOPICS IN QE Bd. 3, Nr. 3, Juni 1997, Seiten 937 - 942

## Beschreibung

Die vorliegende Erfindung bezieht sich auf Verfahren zur Kontaktierung von Schaltungschips, und insbesondere auf Verfahren zur Kontaktierung von Schaltungschips, die auf die Oberfläche eines Trägersubstrats aufgebracht sind.

Chipkarten ohne Außenkontakte, die Transponder zur Übertragung von Energie und Daten verwenden, finden vermehrt Anwendung. Beispiele hierfür sind Krankenversicherungskarten, Bankkarten oder Kreditkarten, die derzeit vielfach noch kontaktbehaftet sind. Die Tendenz geht allgemein dahin, diese Chipkarten mit einem möglichst dünnen Aufbau zu realisieren. Derzeit beträgt die übliche Dicke der in den Chipkarten verwendeten integrierten Schaltungen noch 150 µm und darüber, wobei jedoch eine Entwicklungstendenz zu geringeren Dicken in der Größenordnung von 100 µm zu beobachten ist.

Für zukünftige Anwendungen, die über die Chipkarten hinausgehen und die die Kombination von integrierten Schaltungen mit Papier bzw. papierähnlichen Materialien vorsehen, beispielsweise elektronischen Etiketten, wäre es jedoch vorteilhaft, Schaltungschips mit Dicken deutlich unter 50 µm zu verwenden, wobei eine angestrebte Größenordnung bei ca. 10 µm liegt. Beispiele bekannter derartiger Anwendungen sind in der DE 4432254, der DE 19713799.7 bzw. der DE 19739474.4 beschrieben. Die genannten Anwendungen sind dem Niederpreisbereich zuzurechnen, wobei jedoch riesige Stückzahlen derartiger Chipkarten oder elektronischer Etiketten zu fertigen sind, so daß eine ständige Bestrebung dahingehend existiert, die Herstellungskosten zu minimieren.

Über die Verwendung von Siliziumchips mit Dicken von weniger als 50 µm und eine entsprechende Aufbau- und Verbindungstechnik gibt es derzeit keine Offenbarungen. Aus Multichip-Modul-Anwendungen ist es bekannt, Chips in Aussparungen des Trägersubstrats einzubetten. Zu diesem Zweck wird in dem Trägersubstrat eine Öffnung hergestellt, die nur minimal größer als der einzubettende Chip sein darf. Anschließend wird der Chip in die Öffnung des Substrats eingelegt. Um Chip- und Substratoberfläche möglichst auf einer Ebene zu halten, liegen beide Teile mit der Oberseite nach unten auf einer planaren Glasplatte. Die Spalte zwischen Chip und Substratöffnung werden dann mit einem Polymer aufgefüllt, daß einerseits den Chip in der Öffnung fixiert und andererseits für einen ebenen Übergang vom Substrat zum Chip auf der Oberseite sorgt. Somit entsteht eine quasi-planare Fläche. Anschlüsse zwischen Chip und Umgebung werden anschließend unter Verwendung einer Dünnfilmtechnik hergestellt. Hierbei können auch weitere Leiterbahnen, die dann auch über den Chip verlaufen können, aufgebracht werden. Das oben genannte Verfahren ist jedoch für die Massenfertigung von Transponderchips bzw. elektronischen Etiketten unter Verwendung der Transpondertechnik viel zu aufwendig und zu teuer.

Eine andere Möglichkeit, eine Ankontaktierung dünner Chips durchzuführen, ist die Flip-Chip-Technik. Bei dieser Technik wird der Chip mit der aktiven Seite und seinen Anschlußflächen nach unten auf entsprechende Anschlußflächen des Substrats gelötet oder geklebt. Um einen sicheren Kontakt zu gewährleisten, werden die Anschlußflächen auf einer oder beiden Seiten mit sogenannten Bumps versehen. Dies sind metallische Höcker. Jedoch liegt die Dicke einer solchen Verbindung deutlich über 30 µm, in den meisten Fällen sogar über 50 µm. Um die Vorteile eines insgesamt eher flachen Aufbaus unter Verwendung der Flip-Chip-Technik nutzen zu können, sind erhebliche Entwicklungsanstrengungen zur Verringerung der Dicke der Verbindungsfugen nötig. Dazu werden die Wafer werden von der Rückseite her gedünnt, wozu sie auf einem Hilfs- oder Zwischenträger befestigt werden müssen. Damit die aktive Seite der gedünnten Wafer dann wieder für die Flip-Chip-Verbindungstechnik zugänglich wird, ist nachfolgend ein Umbonden auf einen anderen Zwischenträger nötig. Die Flip-Chip-Verbindungstechnik ist somit zum einen zur Erzeugung flacher Verbindungen ungeeignet und zum anderen aufgrund der oben angesprochenen Problematik des Umbondens aufwendig.

Die DD 13 44 71 offenbart ein Verfahren zur Kontaktierung von Halbleiterchips mit Trägerkörpern, bei dem zunächst eine Isolationsschicht auf einem Trägerkörper gebildet wird. Die Isolationsschicht weist eine Ausnehmung auf, in die nachfolgend ein Halbleiterchip eingebracht wird, derart, daß die Oberfläche des Halbleiterchips bündig mit der Oberfläche der Isolationsschicht ist. Die Kontaktierung des Halbleiterchips erfolgt dann durch Siebdrucken auf der Oberfläche des Halbleiterchips und der Oberfläche der Isolationsschicht.

Die US 5 155 068 A zeigt ein Verfahren zur Herstellung eines IC-Moduls für eine Chipkarte, wobei das IC-Modul nach seiner Herstellung in eine Ausnehmung der Chipkarte eingebracht wird.

Die DE 196 42 378 A1, das nächstliegende Dokument zum Stand der Technik beschreibt eine kontaktlose Chipkarte, bei der ein Chip in einem Chipkartensubstrat im wesentlichen bündig angeordnet ist. Auf dem Chipkartensubstrat ist ferner eine Spulenstruktur derart angeordnet, daß sich dieselbe bis zu Anschlußflächen des Chips erstreckt.

Dieses Dokument beschreibt auch ein Verfahren zur Kontaktierung eines eine integrierte Schaltung enthaltenden Schaltungschips, der zumindest zwei Anschlußflächen auf seiner Oberseite aufweist, wobei eine strukturierte Metallisierung mittels eines Siebdruckverfahrens oder eines Stempelverfahrens auf die Oberseite des Schaltungschips und auf die Oberfläche des Trägersubstrats zum Erzeugen einer peripheren Leiterstruktur, die mit den Anschlußflächen des Schaltungschips verbunden ist, aufgebracht wird.

Die DE 44 31 606 A zeigt ein Chipkartenmodul, bei dem ein Chip in eine Ausnehmung in einem Trägerkörper eingeklebt ist, wobei der Chip teilweise aus dem Trägerkörper vorsteht. Enden einer auf dem Trägerkörper angeordneten Lackdrahtspule sind an Anschlußflächen des Chips gelötet.

Bei H. Wada, T. Kamijoh, IEEE J. of Selected Topics in QE, Vol. 3, No. 3, Juni 1997, Seiten 937 - 942, ist es bekannt, daß Doppelheterostrukturen eines kantenemittierenden InP-InGaAsP-Lasers, die mittels Waferbonden auf ein Siliziumsubstrat aufgebracht sind, eine geringe Dicke im Bereich von beispielsweise 3 µm aufweisen können.

Aus der nachveröffentlichten WO 98/44452 ist ein Verfahren zum Erzeugen einer Antennenmetallisierung beschrieben, die mit auf der Oberseite eines auf einem Trägersubstrats vorgesehenen Chips angeordneten Anschlußflächen verbunden ist. Die Antennenmetallisierung wird durch eine Dispensiertechnik aufgebracht.

Der vorliegenden Erfindung liegt die Aufgabe zugrunde, Verfahren zu schaffen, mit denen sehr kostengünstig in einem Arbeitsschritt sowohl die elektrische Ankontaktierung eines dünnen Schaltungschips an eine periphere Leiterstruktur realisiert werden kann, und zum anderen gleichzeitig mit der Erzeugung einer peripheren Leiterstruktur eine Ankontaktierung des dünnen Schaltungschip erfolgt.

Diese Aufgabe wird durch Verfahren gemäß Patentanspruch 1 gelöst.

Die vorliegende Erfindung basiert auf der Erkenntnis, daß es bei der Verwendung von dünnen Schaltungschips einer Dicke von weniger als 50 µm, vorzugsweise in einem Bereich von 10 bis 20 µm, möglich ist, ein Siebdruckverfahren bzw. ein Stempelverfahren zur Ankontaktierung von auf der Oberseite des Schaltungschips befindlichen Anschlußflächen durchzuführen, selbst wenn der Chip auf die Oberfläche des Trägersubstrats aufgebracht ist. Somit ist es nicht notwendig, den Schaltungschip durch aufwendige Verfahren in dem Trägersubstrat zu versenken. Dadurch ermöglicht das erfindungsgemäße Verfahren eine extrem kostengünstige Herstellung von beispielsweise Transpondermodulen, die in IC-Karten oder elektronischen Etiketten eingesetzt werden.

Das beschriebene Verfahren ist besonders vorteilhaft anwendbar bei integrierten Schaltungen, d.h. Schaltungschips, mit wenigen Anschlußflächen, beispielsweise Transpondern mit nur zwei Anschlußflächen für die Spule, da hier an die laterale Strukturauflösung keine allzu großen Anforderungen gestellt werden, da die gleichzeitig mit der Ankontaktierung mitgedruckte Spule kein komplexes Leiterbahngebilde darstellt.

Die erfindungsgemäßen Verfahren sind insbesondere hinsichtlich der Wirtschaftlichkeit und Flexibilität vorteilhaft. Beispielsweise kann bei der Herstellung von Transpondermodulen im Mehrfachnutzen und/oder von Rolle zu Rolle gearbeitet werden, wobei Stückzahlen von mehreren tausend pro Stunde möglich sind. Aufgrund der Flachheit der fertiggestellten Struktur, die durch die erfindungsgemäßen Verfahren realisiert wird, ist es ohne weiteres möglich, die Struktur in dünne Medien, beispielsweise Papier, einzulaminieren. Somit kann die Dicke heutiger Chipkarten, die üblicherweise bei etwa 0,7 mm liegen, auf etwa 0,2 mm gesenkt werden.

Weiterbildungen der erfindungsgemäßen Verfahren sind in den abhängigen Ansprüchen dargelegt.

Bevorzugte Ausführungsbeispiele der vorliegenden Erfindung werden nachfolgend bezugnehmend auf die beiliegenden Zeichnungen näher erläutert. Es zeigen:
- Fig. 1: eine schematische Querschnittansicht eines Transpondermoduls, das durch das erfindungsgemäße Verfahren hergestellt ist;
- Fig. 2: eine Draufsicht des in Fig. 1 gezeigten Transpondermoduls; und
- Fig. 3: eine schematische Querschnittansicht eines Transpondermoduls, das mittels eines alternativen Ausführungsbeispiels des erfindungsgemäßen Verfahrens hergestellt wurde.

Bevor nachfolgend bevorzugte Ausführungsbeispiele des erfindungsgemäßen Verfahrens näher erläutert werden, seien die folgenden grundlegenden Erwägungen angestellt. Die Grundlagen der Erfindung sind soweit gedünnte Schaltungschips, d.h. integrierte Schaltungen, daß nach dem Aufbringen der Chips auf ein Trägersubstrat, was üblicherweise durch Aufkleben derselben realisiert wird, die entstehende Stufe an der Chipkante sehr klein ist. Diesbezüglich geht die vorliegende Erfindung von einer maximalen Dicke der Schaltungschips von 50 µm aus, wobei eine Dicke derselben von 10 bis 20 µm bevorzugt ist. Somit stellt die oben genannte entstehende Stufe kein Hindernis mehr für die bekannten Siebdruckverfahren oder Stempeltechniken dar. Daher ist es möglich, in einem Arbeitsschritt sowohl die Ankontaktierung der integrierten Schaltungen als auch die Erzeugung eines Leiterbahnbildes auf dem Trägersubstrat durchzuführen.

Die Schaltungsstruktur der verwendeten Chips wird, wie in Massenfertigungsverfahren üblich, fertiggestellt, während sich die Schaltungschips noch im Waferverbund befinden. Nach der Fertigstellung der Schaltungsstruktur in der Vorderseite des Wafers wird ein Zwischenträger auf diese Vorderseite aufgebracht, woraufhin der Wafer von der Rückseite her gedünnt wird. Nachfolgend werden die Schaltungschips vereinzelt, wobei im Falle eines starren Zwischenträgers, der vorteilhafterweise eine durchsichtige Glasplatte ist, dieser mitzerteilt wird. Ist ein flexibler Zwischenträger, beispielsweise eine Folie verwendet, wird nur der gedünnte Wafer zerteilt. Diese vereinzelten dünnen Schaltungschips mit einer Dicke von weniger als 50 µm, vorzugsweise in einem Bereich von 10 bis 20 µm, bilden die Grundlage des erfindungsgemäßen Verfahrens.

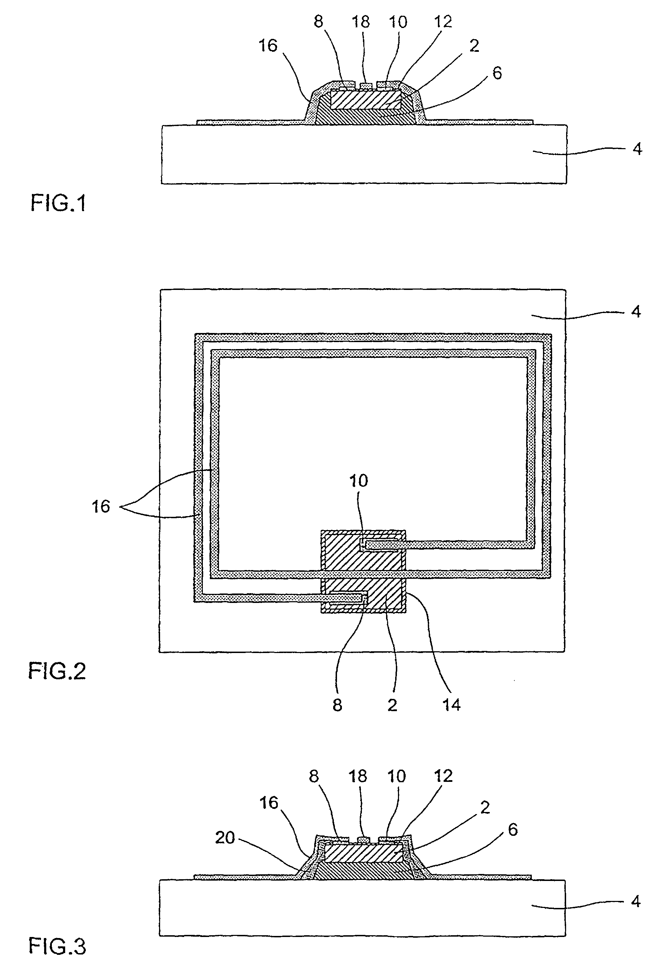

Wie nun in Fig. 1 gezeigt ist, wird gemäß der vorliegenden Erfindung ein solcher dünner Schaltungschip 2 mit einer Hauptoberfläche desselben auf die Hauptoberfläche des Trägersubstrats 4 aufgebracht. Als Trägersubstrat kann hierbei ein beliebiges Substrat geringer Dicke verwendet werden, beispielsweise eine flexible Polymerfolie. Der Schaltungschip 2 wird vorzugsweise mittels eines Haftmittels auf das Trägersubstrat 4 geklebt, wobei die Dicke der Klebefuge 6 so gering wie möglich zu realisieren ist. Eine beispielhafte Dicke der Klebefuge beträgt 1 bis 2 µm. Gleichzeitig mit dem Aufbringen des Schaltungschips 2 auf das Schaltungssubstrat 4 oder nach demselben wird der Zwischenträger (nicht gezeigt) von dem Schaltungschip 2 entfernt, wobei der Zwischenträger beispielsweise mittels eines Schmelzklebers, einer Adhäsionsfolie oder einer doppelseitige Klebefolie mit unterschiedlichen Klebeeigenschaften der beiden Seiten an dem Schaltungschip angebracht war. Falls ein flexibler Zwischenträger verwendet wird, kann der Chip von dem flexiblen Zwischenträger "abgestempelt" werden.

Wie in Fig. 1 gezeigt ist, weist der Schaltungschip 2 zwei Anschlußflächen 8 und 10 auf der von dem Trägersubstrat 4 beabstandeteten Hauptoberfläche desselben auf. Um eine möglichst einfache Kontaktierung des Schaltungschips 2 zu gewährleisten, sind diese Anschlußflächen 8 und 10 möglichst großflächig ausgestaltet. Der Schaltungschip 2 ist oder wird auf der ersten Hauptoberfläche mit Ausnahme der Bereiche, in denen die Anschlußflächen 8, 10 angeordnet sind, vorzugsweise mit einer Passivierungsschicht versehen, um die Chipkanten elektrisch von den darüber laufenden Metallisierungsstrukturen bwz. Leiterbahnen zu isolieren.

Bei dem in Fig. 1 dargestellten Ausführungsbeispiel wird der Schaltungschip derart in einen auf dem Trägersubstrat 4 vorgesehenen elektrisch nicht leitenden Kleber 6 gedrückt, daß die Ränder des Schaltungschips 2 mit Kleber bedeckt sind, der Kleber jedoch nicht auf die Anschlußflächen 8 und 10 des Schaltungschips 2 gelangt. Somit sind die Seiten des Schaltungschips 2 bereits mit einer isolierenden Schicht bedeckt, so daß vor einem Metallisierungschritt keine weitere Isolation derselben notwendig ist.

Nachfolgend wird bei einem Ausführungsbeispiel der vorliegenden Erfindung mittels eines Siebdruck-Verfahrens oder eines Stempel-Verfahrens eine Leiterbahnstruktur 16, siehe insbesondere Fig. 2, derart auf das Trägersubstrat 4 und den Schaltungschip 2 aufgebracht, daß dieselbe zum einen eine periphere Leiterstruktur in der Form einer Antennenspule definiert und zum anderen mit den Anschlußflächen 8, 10 des Schaltungschip 2 verbunden ist. Für dieses Aufbringen der Metallisierungsschicht werden in ihren Eigenschaften auf das Trägersubstratmaterial abgestimmte Leitpasten verwendet. Nach diesem Aufbringen der Metallisierung besitzt das Transpondermodul den in den Fig. 1 und 2 gezeigten Aufbau, wobei Bereiche der Spulenmetallisierung, siehe beispielsweise 18 in Fig. 2, über den Schaltungschip 2 verlaufen, um eine andernfalls notwendige Überbrückungsmetallisierung zu vermeiden.

Gemäß einem alternativen Ausführungsbeispiel des erfindungsgemäßen Verfahrens können die Leiterbahnstrukturen, die die Antennenspule definieren, bereits auf dem Trägersubstrat vorliegen, wobei bei dem Siebdruckverfahren bzw. Stempelverfahren lediglich die Verbindungen der Anschlußflächen mit der bereits vorliegenden Leiterbahnstruktur, bzw. der über den Schaltungschip 2 verlaufende Abschnitt der Spulenmetallisierung gebildet wird.

In Fig. 3 zeigt eine schematische Querschnittansicht eines Transpondermoduls, das mittels eines alternativen Ausführungsbeispiels des erfindungsgemäßen Verfahrens hergestellt wurde. Dabei sind für gleiche Komponenten gleiche Bezugszeichen wie in den Figuren 1 und 2 verwendet. Bei dem in Fig. 3 gezeigten Transpondermodul wurde der Chip nicht derart in einen elektrisch leitenden Kleber eingedrückt, daß die Seiten des Chips bereits vollständig mit dem Kleber bedeckt sind. Vielmehr wird hier vor dem Aufbringen der Metallisierungsschicht 16 eine zusätzliche isolierende Schicht 20 über die Kanten des Schaltungschips 2 aufgebracht. Dieses Aufbringen einer isolierenden Schicht kann beispielsweise durch Dispensen, Stempeln oder Siebdrucken erfolgen.

Die vorliegende Erfindung schafft somit ein äußerst einfaches Verfahren zur Kontaktierung eines Schaltungschips, das vorteilhaft zur Herstellung von ultraflachen Modulen, beispielsweise Transpondermodulen, eingesetzt werden kann. Dabei nutzt die vorliegende Erfindung die Verwendung ultraflacher Schaltungschips aus, dahingehend, daß erkannt wurde, daß trotz des Aufbringens eines solchen Chips direkt auf die Oberfläche eines Trägersubstrats Siebdruckverfahren bzw. Stempelverfahren zum Anbringen einer Metallisierungsschicht, die eine Kontaktierung zu auf der Oberseite des Schaltungschips angeordneten Anschlußflächen erzeugt, verwendet werden können.

## Patentansprüche

1. Verfahren zur Kontaktierung eines eine integrierte Schaltung enthaltenden Schaltungschips (2) einer Dicke von weniger als 50 µm, der zumindest zwei Anschlußflächen (8, 10) auf seiner Oberseite aufweist, mit folgenden Schritten:
Aufbringen des Schaltungschips (2) mit seiner Unterseite auf eine Oberfläche eines Trägersubstrats (4), derart, daß der Schaltungschip (2) mit seiner gesamten Dicke von der Oberfläche des Trägersubstrats (4) vorsteht; und
Aufbringen einer strukturierten Metallisierung (16) mittels eines Siebdruckverfahrens oder Stempelverfahrens auf die Oberseite des Schaltungschips (2) und auf die Oberfläche des Trägersubstrats (4) zum Erzeugen einer peripheren Leiterstruktur (16), die mit den Anschlußflächen des Schaltungschips (2) verbunden ist, auf der Oberfläche des Trägersubstrats (4) und der Oberseite des Schaltungschips (2).

2. Verfahren nach Anspruch 1, bei dem die periphere Leiterstruktur (16) zum Verbinden der Anschlußflächen (8, 10) des Schaltungschips (2) mit einer auf der Oberfläche des Trägersubstrats (4) angeordneten Leiterstruktur (16) dient.

3. Verfahren zur Kontaktierung eines Schaltungschips nach einem der Ansprüche 1 oder 2, bei dem der Schaltungschip (2) mittels eines Hilfsträgers auf die Oberfläche des Trägersubstrats (4) aufgebracht wird.

4. Verfahren zur Kontaktierung eines Schaltungschips nach einem der Ansprüche 1 bis 3, bei dem der Schaltungschip (2) auf die Oberfläche des Trägersubstrats (4) geklebt wird.

5. Verfahren nach Anspruch 4, bei dem eine Haftmittelschicht (14) auf dem Trägersubstrat (4) vorgesehen ist, in die der Schaltungschip derart gedrückt wird, daß die Ränder des Schaltungschips (2) durch die Haftmittelschicht (14) isoliert werden.

## Claims

1. Method for contacting a circuit chip (2) containing an integrated circuit of a thickness less than 50 µm, which has at least two pads (8, 10) on its upper side, comprising the steps of:
applying the circuit chip (2) with its underside onto a surface of a support substrate (4), in such a way that the entire thickness of the circuit chip (2) protrudes from the surface of the support substrate (4); and
applying a structured metallic coating to the upper face of the circuit chip (2) and to the surface of the support substrate (4) by means of screen printing or stamping in order to create a peripheral conductor structure (16) connected to the pads of the circuit chip (2), both on the upper face of the support substrate (4) and on the upper face of the circuit chip (2).

2. Method in accordance with claim 1, wherein the peripheral conductor structure (16) serves for connecting the pads (8, 10) of the circuit chip (2) to a conductor structure (16) disposed on the upper face of the support substrate (4).

3. Method for contacting a circuit chip in accordance with claim 1 or 2, wherein a circuit chip (2) is placed onto the surface of the support substrate (4) by means of an auxiliary support.

4. Method for contacting a circuit chip in accordance with one of the claims 1 to 3, wherein the circuit chip (2) is adhered to the surface of the support substrate (4).

5. Method in accordance with claim 4, wherein a layer of bonding agent (14) is provided on the support substrate (4), in which the circuit chip is pressed in such a way that the edges of the circuit chip (2) are insulated by the layer of bonding agent (14).

## Revendications

1. Procédé de mise en contact d'une puce de circuit (2) comportant un circuit intégré, d'une épaisseur de moins de 50 µm et présentant au moins deux surfaces de connexion (8, 10) sur sa face supérieure, aux étapes suivantes consistant à :
appliquer la puce de circuit (2) par sa face inférieure sur une surface d'un substrat support (4) de sorte que la puce de circuit (2) fasse saillie, sur toute son épaisseur, par rapport à la surface du substrat support (4) ; et
appliquer une métallisation structurée (16) au moyen d'un procédé d'impression sérigraphique ou d'un procédé de poinçonnage sur la face supérieure de la puce de circuit (2) et sur la surface du substrat support (4), pour générer une structure conductrice périphérique (16), connectée aux surfaces de connexion de la puce de circuit (2), sur la surface du substrat support (4) et sur la face supérieure de la puce de circuit (2).

2. Procédé selon la revendication 1, dans lequel la structure conductrice périphérique (16) sert à assembler les surfaces de connexion (8, 10) de la puce de circuit (2) avec une structure conductrice (16) disposée sur la surface du substrat support (4).

3. Procédé de mise en contact d'une puce de circuit selon l'une des revendications 1 ou 2, dans lequel la puce de circuit (2) est appliquée sur la surface du substrat support (4) au moyen d'un support auxiliaire.

4. Procédé de mise en contact d'une puce de circuit selon l'une des revendications 1 à 3, dans lequel la puce de circuit (2) est collée sur la surface du substrat support (4).

5. Procédé selon la revendication 4, dans lequel est prévue, sur le substrat support (4), une couche de substance adhésive (14) dans laquelle la puce de circuit est enfoncée de sorte que les bords de la puce de circuit (2) soient isolés par la couche de substance adhésive (14).
